# FASCICULE DE BREVET EUROPEEN

(11) **EP 2 853 004 B1**
(45) Date de publication et mention de la délivrance du brevet: **17.08.2016**
(21) Numéro de dépôt: 12710693.8
(22) Date de dépôt: 19.03.2012
(51) Int. Cl.: H01P 5/04

(54) **SYNTHÉTISEUR D'IMPÉDANCE COAXIAL**
KOAXIALIMPEDANZ-SYNTHESIZER
COAXIAL-IMPEDANCE SYNTHESIZER

(30) Priorité: 18.03.2011 FR 1152236
(43) Date de publication de la demande: 01.04.2015
(73) Titulaire: Curutchet, Arnaud, 33700 Mérignac (FR)
(72) Inventeur: Curutchet, Arnaud, 33700 Mérignac (FR)
(74) Mandataire: Le Forestier, Eric
(86) Numéro de dépôt international: PCT/EP2012/054845
(87) Numéro de publication internationale: WO 2012/126900

(56) Documents cités:
- EP-A2- 0 899 809
- WO-A1-2007/010134
- JP-A- 6 177 614
- JP-A- 2004 007 056
- US-A- 3 792 385
- US-B1- 6 674 293

## Description

### Domaine technique général

La présente invention se rapporte au domaine de l'électronique aux hyperfréquences, par exemple pour de l'instrumentation de mesure.

### Présentation de l'art antérieur

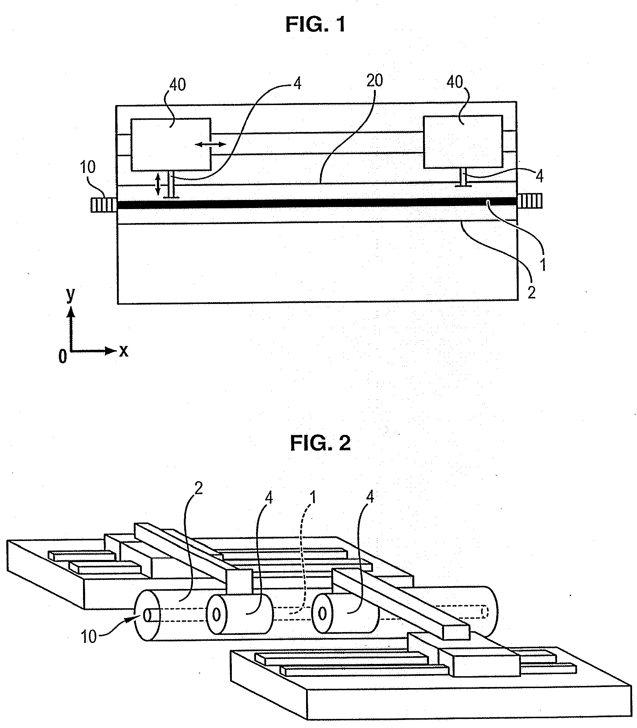

Comme l'illustre la Figure 1, on connaît des adaptateurs d'impédance (également appelés 'tuners' par l'homme du métier) comprenant un conducteur coaxial dont la partie extérieure 2 est fendue par une fente 20 dans le sens de sa longueur, repérée par l'axe 0x. Cette fente 20 permet le passage d'une ou plusieurs sondes 4 de type plongeur que l'on peut déplacer indépendamment l'une par rapport à l'autre, non seulement suivant l'axe 0x, mais également suivant l'axe 0y, orthogonal à 0x. En modifiant la distance séparant chaque plongeur 4 d'un conducteur 1 central du conducteur coaxial, on modifie l'impédance caractéristique du bout 10 de ligne correspondant. Lorsque le ou les plongeur(s) 4 sont éloignés au maximum du conducteur 1 central, le tuner présente une impédance égale à 50Ω.

Il existe également des chariots 40 mobiles équipés dans les versions automatiques de moteurs assurant le déplacement des plongeurs 4 sur l'axe 0y et selon l'axe 0x.

Les tuners de type plongeur 4 peuvent être facilement étalonnés. L'entrée et la sortie sont connectées à un analyseur de réseau vectoriel (VNA), et pour plusieurs centaines de positions du ou des plongeur(s) 4 suivant l'axe 0x, ou suivant l'axe 0y entre le ou les plongeur(s) 4 et le conducteur 1 central, on enregistre les impédances synthétisées.

Lorsque l'on souhaite utiliser le tuner pour la caractérisation de composants électroniques en puissance ou en bruit, on commande donc au tuner telle ou telle impédance via un logiciel de commande du tuner, qui idéalement pilote également le VNA. On comprend que la répétabilité du tuner est un facteur clef pour la caractérisation.
Le tuner selon la Figure 1 présente des inconvénients.

Les performances hyperfréquences sont en effet réduites par les pertes d'insertion du tuner, liées à la transition entre le connecteur coaxial et le conducteur central 1. Si l'on représente les impédances sur un abaque de Smith, on constate alors des « zones mortes » en bord d'abaque, à cause de ces pertes d'insertion.

De plus, de tels plongeurs 4 peuvent provoquer des fuites de charge.

En outre, les tuners à plongeurs 4 sont réalisés avec des platines (non représentées sur les Figures) qui se déplacent suivant l'axe 0x, grâce à l'emploi de moteurs pas à pas. Chaque platine supporte en outre un moteur permettant de réaliser le déplacement des plongeurs suivant l'axe 0y.

On comprend donc que ces platines ont une certaine inertie. La vitesse de déplacement des platines en est pénalisée, ce qui a pour effet d'augmenter le temps nécessaire pour synthétiser des impédances nécessitant le déplacement des platines.

De par ce mode de conception, des vibrations peuvent apparaître au niveau du ou des plongeurs 4, ce qui peut altérer les performances du tuner. Les vibrations engendrées par le tuner peuvent également être à l'origine d'une dégradation des contacts des composants mesurés sur substrat (« on wafer »).

Au surplus, ce mode de conception débouche sur des tuners volumineux et relativement lourds, ce qui pénalise leur utilisation pour les mesures réalisées sur station sous pointes, dans le cadre de caractérisation sur substrat (« on wafer »). Etant volumineux, il est impossible de placer ces tuners au plus prés des composants mesurés, ce qui inévitablement augmente les pertes d'insertion, et donc les « zones mortes » sur l'abaque de Smith.

Des systèmes de préadaptation peuvent être éventuellement connectés entre les pointes hyperfréquences et le tuner pour pallier ce problème.

Cependant, ces systèmes sont particulièrement rigides, ce qui augmente les problèmes de vibrations au bout des pointes et de dégradation des contacts des composants. Dans les cas extrêmes, cela peut conduire à une destruction du composant mesuré, voir des pointes hyperfréquences.

Enfin, le plus gros problème des tuners à plongeur concerne la fiabilité. En effet, le déplacement des plongeurs suivant l'axe Oy doit être particulièrement précis avec des précisions de l'ordre du micromètre. Lorsque l'on est amené à déplacer le tuner pour le monter ou le démonter d'un banc de mesure, un petit choc peut suffire pour dégrader le mécanisme d'asservissement des plongeurs suivant l'axe Oy. Si en cours d'utilisation un plongeur 4 vient percuter le conducteur 1 central du connecteur coaxial, le tuner est hors service.

Comme le montre la Figure 2, on connaît également par WO2007/010134A1 un tuner coaxial à double sondes 4 (également appelé tuner « double slug ») qui permet théoriquement de répondre au mieux à la caractérisation des transistors de puissance et de bruit.

Ce tuner est prévu pour fonctionner dans des larges bandes de fréquence : il peut fonctionner dans des fréquences allant de 0,25 à 250GHz. Les deux sondes 4 ne présentent qu'un mouvement de translation le long d'un conducteur 1 coaxial repéré suivant l'axe Ox.

Le principe électromagnétique consiste en un déplacement de deux bouts 4 de ligne d'impédances caractéristiques différentes de 50Ω. Ces bouts 4 de ligne sont réalisés avec les sondes 4.

En fonctionnement,
1. une première sonde 4, dite de préadaptation, se déplace sur une distance λ/2, où λ est la longueur d'onde pour une fréquence de signal donné, et
2. une deuxième sonde 4 se déplace sur une longueur λ/2 par rapport à la première sonde 4.
Le tuner selon la Figure 2 présente des inconvénients.

Le tuner est prévu pour fonctionner uniquement à la fréquence fondamentale, c'est-à-dire que l'on ne peut pas travailler sur les différents harmoniques, ce qui nécessiterait l'emploi d'un plus grand nombre de sondes.

Le tuner présente de nombreuses limitations, et les performances électromagnétiques sont non optimales.

Pour permettre le déplacement des sondes 4, il est en effet nécessaire de réaliser un ajustement de type glissant entre le diamètre extérieur des sondes 4 et le diamètre intérieur du conducteur 2 extérieur. En dehors du fait que le déplacement des sondes 4 engendre une usure inévitable par frottement, ce jeu nécessaire rend médiocre et inhomogène le contact électrique entre l'extérieur des sondes 4 et l'intérieur du tube 2 formant le conducteur extérieur du conducteur coaxial. La coaxialité entre les sondes 4 et le conducteur coaxial n'est pas complètement maîtrisée, et quelques dixièmes de degré de différence suffisent pour considérablement changer les résultats pratiques des résultats théoriques. Ce problème engendre inévitablement des problèmes de répétabilité, rendant l'emploi du tuner impossible pour une caractérisation d'un composant électronique.

Qui plus est, si les sondes 4 se mettent légèrement de travers, cela peut engendrer une destruction du mécanisme, pour peu qu'une des sondes 4 vienne accrocher une quelconque aspérité située à l'intérieur du conducteur 2 extérieur.

Un autre défaut majeur du tuner selon la Figure 2 est l'impossibilité de présenter une impédance de 50Ω lors de son utilisation, puisque cela nécessiterait de pouvoir enlever les sondes 4. Ceci est possible mais nécessite le démontage des connecteurs, donc le démontage de l'instrument de la chaîne de mesure dont il fait partie.

En outre, le changement des sondes 4 n'est pas aisé, puisqu'il nécessite de les sortir par une des extrémités du conducteur coaxial, ce qui nécessite un démontage systématique des connecteurs hyperfréquences. Or, les performances de ces derniers ne sont pas garanties au-delà d'un certain nombre de montage/démontage.

L'emploi d'un quelconque moyen de lubrification reste exclu en raison des problèmes électromagnétiques que cela engendrerait.

Les documents EP 0899809A2 et JP6-177614A décrivent des tuners qui présentent des structures complexes et qui sont susceptibles de donner lieu à des problèmes dans leur exploitation.
L'invention a pour but de pallier au moins un des inconvénients de l'art antérieur.

A cet effet, on propose selon l' invention un synthétiseur d'impédance coaxial tel que défini dans la revendication 1.

L'invention est avantageusement complétée par les caractéristiques des revendications dépendantes 2 à 9.

L'invention présente de nombreux avantages.

Il existe un très bon contact électrique entre la périphérie externe des sondes et la paroi intérieure du conducteur extérieur du conducteur coaxial. C'est en effet dans cette configuration, à savoir quand il y a contact électrique entre les sondes et le conducteur extérieur, lui-même relié à la masse, que l'on obtient les meilleures performances électromagnétiques.

L'invention permet un placement très précis des sondes, ce qui engendre une très bonne répétabilité des impédances synthétisées pour un placement donné des sondes.

Il n'y a aucun frottement des sondes sur le conducteur coaxial. Très peu d'usure, ni des sondes, ni du conducteur coaxial.

Il existe une possibilité de dégagement des sondes du conducteur coaxial, afin que ce dernier puisse présenter une impédance constante sur toute la bande de fréquence, idéalement 50Ω. A cet effet, chaque sonde est avantageusement réalisée en au moins deux parties amovibles l'une par rapport à l'autre, et les parties mobiles du conducteur coaxial doivent permettre de dégager suffisamment d'espace pour permettre le passage des différentes parties des sondes.

Les performances hyperfréquences sont nettement supérieures à celles de tous les autres systèmes de l'art antérieur. En effet, la présente invention permet de synthétiser des impédances à fort coefficient de réflexion, c'est-à-dire qu'il est possible d'aller très près en bord d'abaque de Smith.

L'invention permet d'envisager la réalisation d'une gamme de synthétiseurs d'impédance pouvant fonctionner dans une bande de fréquence allant de 100MHz à 1 THz.

Il est possible de changer les sondes en fonction des applications et des performances désirées par un utilisateur, avantageusement de manière automatique. Selon un mode de réalisation de l'invention, les sondes peuvent ainsi être déplacées et/ou changées automatiquement.

Il n'y a que peu ou pas de vibrations engendrées lors du déplacement des sondes.

L'invention permet une plus grande robustesse et une meilleure fiabilité que les autres tuners de l'art antérieur.

Un tuner selon l'invention permet un faible encombrement pour une gamme de fréquences donnée.

L'invention peut fonctionner dans n'importe quelle position.

L'invention permet de laisser passer les tensions continues.

### Présentation des figures

D'autres caractéristiques, buts et avantages de l'invention ressortiront de la description qui suit, qui est purement illustrative et non limitative, et qui doit être lue en regard des dessins annexés sur lesquels :
- la Figure 1, déjà commentée, présente une vue schématique d'un premier tuner coaxial connu selon l'art antérieur ;
- la Figure 2, déjà commentée également, présente une vue schématique d'un deuxième tuner coaxial connu selon l'art antérieur ;
- la Figure 3A présente une vue en perspective d'un des modes de réalisation possibles d'un synthétiseur d'impédance possible selon l'invention ;
- la Figure 3B est une vue éclatée de la figure 3A ;
- la Figure 4A présente une vue en coupe d'un des modes de réalisation possibles d'un synthétiseur d'impédance possible selon l'invention ;
- la Figure 4B est une vue éclatée de la figure 4A ;
- les Figures 5A et 5B présentent une vue en perspective éclatée d'un autre mode de réalisation possible d'un synthétiseur d'impédance possible selon l'invention, dans lequel les sondes sont amovibles ;
- la Figure 6 présente une vue en coupe d'une sonde possible de type cylindrique, prévue pour être tenue par des pattes de fixation de section rectangulaire ;
- la Figure 7 présente un groupe de sondes de type cylindrique composé de deux sondes séparées d'une certaine distance L ;
- la Figure 8 présente une vue d'un mode de réalisation possible d'un synthétiseur d'impédance selon l'invention.

Sur l'ensemble des figures, les éléments similaires portent des références numériques identiques.

### Description détaillée

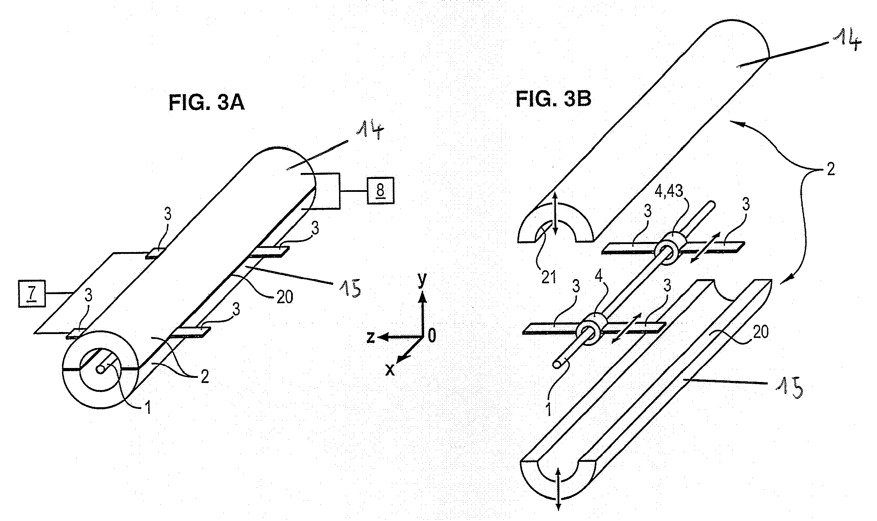

Les Figures 3A et 3B représentent schématiquement un mode de réalisation possible d'un synthétiseur d'impédance selon l'invention.

Le synthétiseur d'impédance comporte principalement un conducteur 1 central longitudinal, s'étendant selon un axe longitudinal 0x et un tube 2 conducteur externe coaxial au conducteur 1 (appelé tube externe par la suite).

Le tube 2 externe comprend deux demi-tubes 14, 15 séparables.

Dans les Figures 3 à 5, le tube est cylindrique. Toutefois, ceci n'est pas obligatoire et il peut s'agir d'un tube carré ou rectangulaire. Il en est de même pour les deux demi-tubes. En outre, les deux demi-tubes ne sont pas nécessairement identiques. Quelle que soit la section du tube, celui-ci est creux, et plus long que large.

Les demi-tubes comprennent au moins deux positions : une position d'éloignement mutuel, illustrée de manière non limitative en Figure 3B, et une position de proximité mutuelle, illustrée de manière non limitative en Figure 3A.

Les deux demi-tubes ne sont pas nécessairement deux entités complètement séparables, et il peut s'agir d'un tube consistant en deux demi-tubes que l'on sépare par déformation plastique du tube.

Le synthétiseur d'impédance comporte en outre au moins une sonde 4, très préférentiellement d'impédance caractéristique différente de 50Ω.

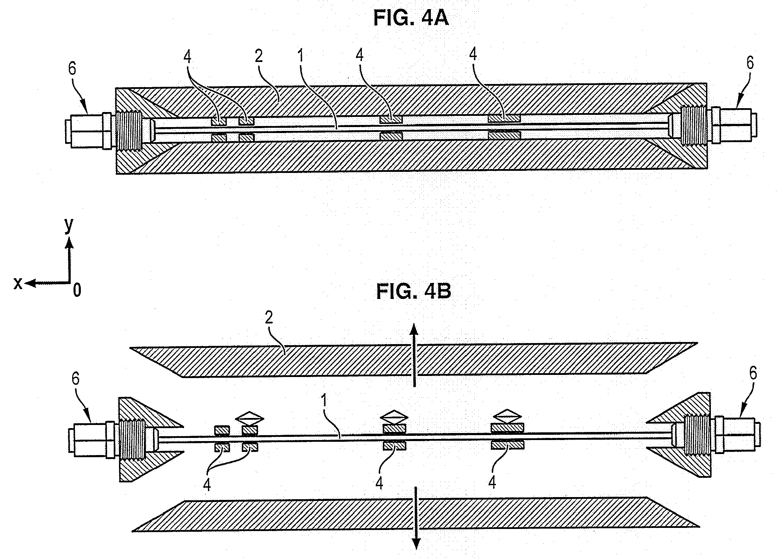

Le synthétiseur d'impédance peut ne comporter qu'une sonde, mais peut également comporter une pluralité de sondes 4, jusqu'à une centaine par exemple. Sur les Figures 3A et 3B, le synthétiseur d'impédance comporte deux sondes, et sur les Figures 4A et 4B, le synthétiseur d'impédance comporte quatre sondes.

Chaque sonde 4 est montée autour du conducteur 1 central, sans contact avec le conducteur 1 central, avec une possibilité de translation longitudinale.

La sonde 4 est autorisée à se déplacer longitudinalement par rapport au conducteur 1 central vers une position désirée lorsque les deux demi-tubes sont dans une position d'éloignement mutuel. L'espace minimum requis entre les deux demi-tubes dans cette position est celui qui permet à la sonde à se déplacer le long du conducteur.

Lorsque les deux demi-tubes sont dans une position de proximité mutuelle, la périphérie 43 externe de la sonde 4 et la paroi 21 intérieure du tube externe sont en contact, réalisant ainsi un synthétiseur d'impédance. La paroi intérieure du tube est constituée des parois intérieures de chacun des demi-tubes.

Dans cette position, les deux demi-tubes sont en contact serré avec la sonde. Ainsi, un contact mécanique est réalisé entre les deux demi-tubes et la sonde. Par conséquent, la sonde est bloquée à la position désirée par l'intermédiaire des deux demi-tubes. Le contact est mécanique, et donc électrique si les deux matériaux (matériaux constitutifs de la périphérie externe de la sonde et de la paroi intérieure du tube) sont conducteurs. Même dans cette position, les deux demi-tubes ne sont pas nécessairement en contact et restent séparés par un espace 20, de type fente longitudinale. Dans un mode de réalisation particulier, il est possible que les deux demi-tubes soient en contact dans cette position: dans ce cas, des pattes de déplacement des sondes de type tige peuvent être utilisées pour déplacer et positionner les sondes, lesdites pattes étant retirées une fois les sondes positionnées.

Le synthétiseur d'impédance est apte à fonctionner dans la bande de fréquences s'étendant de 100MHz à THz.

Ainsi, lorsque les deux demi-tubes se rapprochent, et du fait des cotes mécaniques, les défauts de coaxialité entre les sondes et le conducteur coaxial sont résolus : les sondes sont automatiquement centrées et le contact mécanique, et, le cas échéant, électrique, entre la périphérie externe 43 des sondes 4 et la paroi 21 intérieure du tube 2 du conducteur coaxial est homogène et de bonne qualité.

Avantageusement, lorsque les deux demi-tubes sont dans une position de proximité mutuelle, la périphérie externe de la sonde et la paroi intérieure du tube externe coaxial au conducteur sont en contact sur toute la périphérie de la sonde.

Lorsqu'un utilisateur désire déplacer au moins une sonde 4, et réaliser une synthèse d'impédance, les étapes suivantes sont mise en oeuvre, consistant à :
- produire un éloignement mutuel des deux demi-tubes. Dans le mode de réalisation illustré en Figures 3 à 5, les deux demi-tubes sont éloignés l'un de l'autre.
- déplacer longitudinalement la sonde 4 par rapport au conducteur 1 central vers une position désirée,
- positionner les deux demi-tubes dans une position de proximité mutuelle, de sorte à mettre en contact la périphérie externe de la sonde et la paroi intérieure du tube externe.

Cette sonde est préférentiellement d'impédance caractéristique différente de 50Ω.

Dans un mode de réalisation, la sonde 4 comporte en outre au moins une patte 3 de fixation située dans un espace 20 séparant les deux demi-tubes.

Cet espace 20 prend la forme d'une fente longitudinale lorsque les deux demi-tubes sont dans la position de proximité mutuelle. Cet espace existe de part et d'autre de la sonde, et deux fentes longitudinales séparent donc les deux demi-tubes en position de proximité mutuelle.

Cet espace est plus large lorsque les deux demi-tubes sont en position d'éloignement mutuel, comme les figures le montrent de manière schématique.

La patte 3 est préférentiellement sous forme de plaque rectangulaire, mais peut être de toute forme d'épaisseur relativement fine et se logeant dans l'espace 20, tout en permettant un rapprochement mutuel des deux demi-tubes.

Comme le montrent les doubles flèches pointillées de la Figure 3B, la patte 3 est adaptée pour pouvoir se déplacer longitudinalement dans l'espace 20 lorsque les deux demi-tubes sont en position d'éloignement mutuel, en déplaçant ainsi la sonde 4 par rapport au conducteur 1 central. La patte permet donc notamment de déplacer la sonde.

Lorsque les deux demi-tubes sont en position de proximité mutuelle, la sonde est bloquée par les deux demi-tubes, ce qui implique que la patte 3 est également bloquée en translation.

Lorsque les deux demi-tubes sont dans la position de proximité mutuelle, pour laquelle la sonde est bloquée, la patte peut être également bloquée dans l'espace 20 de type fente existant entre les deux demi-tubes. Toutefois, ceci n'est pas obligatoire, et dépend des dimensions relatives de la patte par rapport à l'espace 20 existant entre les deux demi-tubes en position de proximité mutuelle.

Dans le mode de réalisation préférentiel représenté sur les figures, la sonde 4 comporte deux pattes de fixation 3 situées chacune dans un espace 20, mais pourrait ne comporter qu'une patte par exemple.

Avantageusement, les deux demi-tubes sont séparables par :
- translation selon un axe (0z) perpendiculaire au conducteur 1 central longitudinal, ou
- rotation autour d'un axe (0z) perpendiculaire au conducteur 1 central longitudinal, ou
- rotation autour d'un axe parallèle (0x) au conducteur 1 central longitudinal.

Le déplacement mutuel des demi-tubes du synthétiseur d'impédance peut être fait soit de manière manuelle, soit grâce à un actionneur 8.

Ainsi, comme le montrent les Figures 3A et 3B, le synthétiseur d'impédance peut comporter un actionneur 8 des deux demi-tubes.

L'actionneur 8 peut ainsi comporter un servomoteur, un vérin hydraulique, pneumatique ou électrique, ou un électroaimant par exemple.

De même, le synthétiseur d'impédance peut comporter un actionneur 7 agissant au niveau de la patte 3 de fixation.

L'actionneur 7 peut par exemple comporter des chariots guidés par exemple par des rails linéaires parallèles à l'axe 0x, et actionnés par un moteur.

Plusieurs types de moteurs peuvent être retenus pour réaliser le déplacement des sondes 4, comme par exemple :
- moteur pas à pas associés à des courroies ou des vis sans fin,
- moteur linéaire,
- moteur piézoélectrique, ou
- tout type de vérin.

Pour les synthétiseurs d'impédances dédiés aux applications de l'ordre de 100GHz et plus, étant donné la valeur de la longueur d'onde, les moteurs piézoélectriques semblent être les plus appropriés, puisqu'ils permettent d'obtenir des déplacements d'une précision de l'ordre du nanomètre.

La Figure 4 montre que le synthétiseur d'impédance comporte également des connecteurs 6 coaxiaux, montés aux extrémités et qui permettent de connecter le synthétiseur d'impédance à une chaîne de mesure, pour la caractérisation d'un composant électronique par exemple.

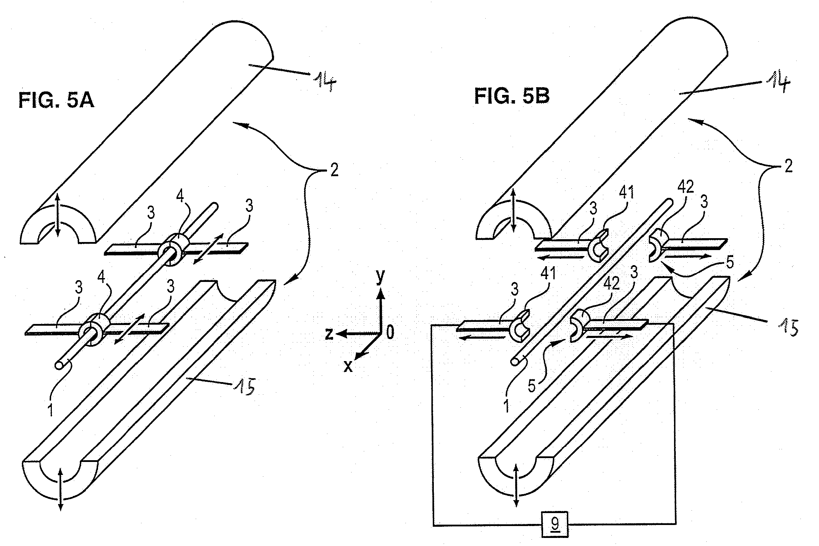

Les Figures 5A et 5B montrent que, selon une variante de réalisation, chaque sonde 4 peut comporter au moins deux parties 41 et 42, fixées l'une à l'autre de manière amovible, de sorte que la sonde 4 peut être montée de manière amovible autour du conducteur 1. Les flèches pointillées de la Figure 5B montrent que les parties 41 et 42 sont amovibles l'une de l'autre. Un utilisateur peut donc à sa guise monter un nombre de sondes 4 plus ou moins important, le conducteur coaxial ne comportant pas de sonde ayant alors une impédance de 50Ω.

La séparation de la partie 41 de la partie 42 peut être manuelle, mais comme le montre également la Figure 5B, le synthétiseur d'impédance peut comporter un actionneur 9 des deux parties 41 et 42, comportant tout type de moteur possible.

On comprend que les actionneurs 7 et/ou 8 et/ou 9 peuvent être confondus, ou indépendants.

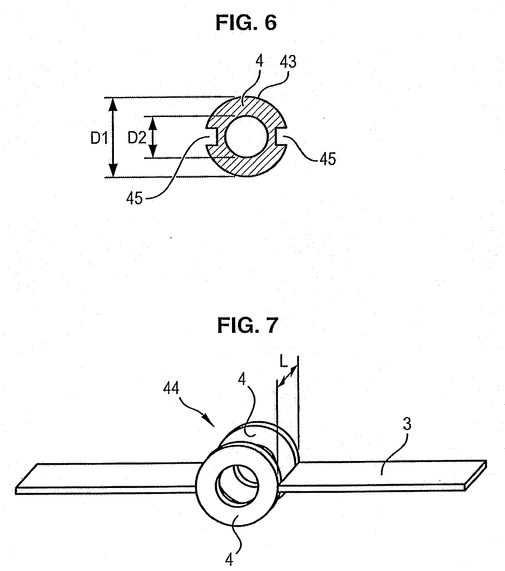

La Figure 6 montre que chaque sonde 4 est préférentiellement de type cylindrique, et comporte au moins une gorge 45 longitudinale, chaque gorge 45 étant prévue pour recevoir une patte 3 de fixation de section complémentaire.

D1 représente le diamètre extérieur de la sonde 4. D1 est choisi pour que la périphérie externe 43 soit en contact serré avec la paroi intérieure 21 du tube 2 du synthétiseur d'impédance, lorsque les deux demi-tubes sont en position de proximité mutuelle.

Par exemple, pour un fonctionnement jusqu'à 34GHz, D1 peut être de 3,5mm.

Le diamètre D2 permet le passage du conducteur 1 central du synthétiseur d'impédance. Il doit être suffisamment grand pour ne pas que la sonde 4 vienne se mettre en court-circuit avec le conducteur 1 central. D2 est déterminant pour les performances hyperfréquences du synthétiseur d'impédance, et peut être déterminé à partir de résultats de simulations électromagnétiques. Le conducteur central 1 peut éventuellement être recouvert d'une couche isolante, pour éviter absolument les courts-circuits entre le conducteur 1 et les sondes 4.

La Figure 7 montre qu'au moins deux sondes 4 peuvent être regroupées pour former un groupe 44 partageant une patte 3 de fixation commune et être séparées d'une certaine distance L déterminée à partir de résultats de simulations électromagnétiques. Ce type de configuration permet de réduire la bande de fréquence de fonctionnement du groupe 44 de sondes, ce qui permet de l'utiliser en tant que résonateur, pour permettre de contrôler l'impédance synthétisée, non pas à une valeur de fréquence mais à deux fréquences distinctes.

D'une manière générale, le nombre de sondes 4 dans le groupe 44 correspond au nombre de fréquences pour lesquelles on peut contrôler l'impédance.

Les sondes et les différents éléments constituant le synthétiseur d'impédance peuvent être réalisés, dans un exemple non limitatif, en métal ou dans un quelconque alliage (inox, laiton, cuivre).

Les dimensions générales de ces différents éléments pourront être validées à partir de simulations électromagnétiques.

Selon une variante avantageuse, les différentes parties pourront recevoir une fine couche d'or dans le but d'améliorer les performances électromagnétiques tout en supprimant les éventuels problèmes de corrosion qui pourraient à long terme dégrader les performances électromagnétiques du synthétiseur d'impédance.

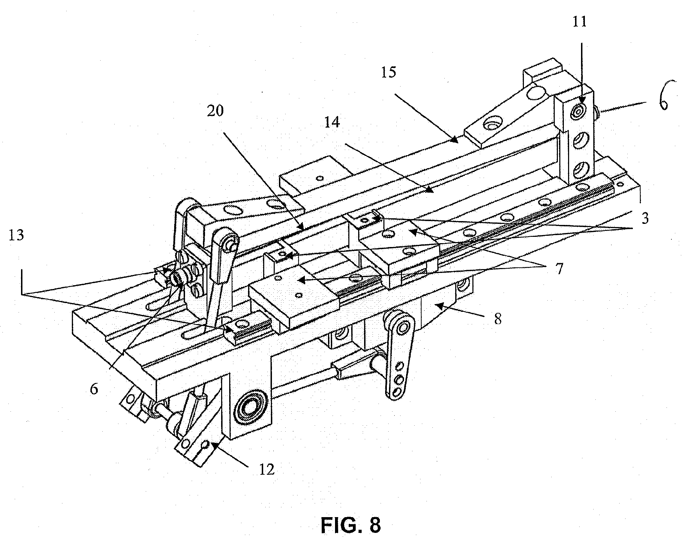

En Figure 8, on a représenté un mode de réalisation du synthétiseur d'impédance. Le tube 2 externe comprend deux demi-tubes 14,15 séparables.

L'un des demi-tubes est fixe, et l'autre des demi-tubes est mobile par rapport au demi-tube fixe, autour d'une articulation en rotation 11. Un actionneur 8 est configuré pour déplacer la partie mobile par rapport à la partie fixe. L'actionneur 8 est lui-même commandé par un mécanisme 12 pour la commande de l'ouverture et de la fermeture du tube 2.

Les deux demi-tubes sont séparés par un espace 20.

Lorsque les deux demi-tubes sont dans une position d'éloignement mutuel, la translation des sondes et des pattes 3 est autorisée.

Lorsque les deux demi-tubes sont dans une position de proximité mutuelle, la périphérie externe de la sonde 4 et la paroi intérieure du tube externe sont en contact. Il s'agit d'un contact serré, pour lequel la sonde est bloquée en translation. Ce contact est mécanique, et électrique si les matériaux en contact sont conducteurs.

Les pattes sont déplacées par des actionneurs 7 de type chariots guidés par des rails 13 linéaires parallèles et actionnés par un moteur.

Le synthétiseur d'impédance comprend en outre au moins un connecteur 6 coaxial à chacune de ses extrémités.

Dans cet exemple de réalisation, le tube présente une section rectangulaire.

## Revendications

1. Synthétiseur d'impédance coaxial, comportant
- un conducteur central (1) longitudinal (Ox),
- un tube conducteur externe (2) coaxial au conducteur central (1),
- au moins une sonde (4) montée autour du conducteur central (1) en translation longitudinale,
le synthétiseur d'impédance coaxial étant **caractérisé en ce que** :
- le tube externe (2) comprend deux demi-tubes déplaçables entre deux positions mutuelles, de sorte que :
• lorsque les deux demi-tubes sont amenés dans une première position d'éloignement mutuel, de réglage du synthétiseur, la sonde (4) est autorisée à se déplacer longitudinalement par rapport au conducteur central (1) vers une position désirée, et
• lorsque les deux demi-tubes sont amenés dans une seconde position de rapprochement mutuel, d'utilisation du synthétiseur, la périphérie externe de la sonde (4) et la paroi intérieure du tube externe sont en contact mécanique, et, le cas échéant, électrique, pour bloquer la sonde (4) en position,
et **en ce que**:
- la sonde (4) comporte au moins une patte (3) de déplacement de la sonde s'étendant dans un espace séparant les deux demi-tubes et permettant de déplacer la sonde dans la première position d'éloignement mutuelle des deux demi-tubes.

2. Synthétiseur d'impédance selon la revendication 1, dans lequel les deux demi-tubes sont déplaçables mutuellement par translation selon un axe (Oz) perpendiculaire au conducteur central longitudinal (1), ou par rotation autour d'un axe (Oz) perpendiculaire au conducteur central longitudinal (1), ou par rotation autour d'un axe parallèle au conducteur central longitudinal (1).

3. Synthétiseur d'impédance selon la revendication 2, comportant un actionneur (8) pour le déplacement mutuel des deux demi-tubes.

4. Synthétiseur d'impédance selon l'une des revendications 1 à 3, dans lequel la sonde (4) comporte au moins deux parties (41, 42), fixées l'une à l'autre de manière amovible, de sorte que la sonde (4) peut être montée de manière amovible autour du conducteur (1).

5. Synthétiseur d'impédance selon la revendication 4, comportant un actionneur commun (9) pour les deux parties (41, 42).

6. Synthétiseur d'impédance selon l'une des revendications 1 à 5, comportant un actionneur (7) agissant au niveau de la ou chaque patte (3) de déplacement.

7. Synthétiseur d'impédance selon l'une des revendications 1 à 6, dans lequel, lorsque les deux demi-tubes sont dans leur seconde position mutuelle, la périphérie externe de la sonde et la paroi intérieure du tube externe sont en contact sur toute la périphérie de la sonde.

8. Synthétiseur d'impédance selon l'une des revendications 1 à 7, comportant une pluralité de sondes (4).

9. Synthétiseur d'impédance selon la revendication 8, comportant un groupe (44) d'au moins deux sondes (4) partageant au moins une patte (3) de déplacement commune.

## Patentansprüche

1. Koaxialimpedanz-Synthesizer, umfassend
- einen langestreckten (Ox) Zentralleiter (1),
- ein leitfähiges Außenrohr (2), koaxial mit dem Zentralleiter (1),
- mindestens eine Sonde (4), die um den Zentralleiter (1) in Längsrichtung verschiebbar angeordnet ist,
wobei der Koaxialimpedanz-Synthesizer **dadurch gekennzeichnet ist, dass**
- das Außenrohr (2) zwei zwischen zwei Stellungen zueinander versetzbare Halbrohre umfasst, derart, dass
• die Sonde (4) die Möglichkeit hat, sich in Längsrichtung relativ zum Zentralleiter (1) an eine gewünschte Stelle zu verschieben, wenn die beiden Halbrohre in eine erste, voneinander entfernte Stellung zur Einstellung des Synthesizers gebracht sind, und
• die äußere Peripherie der Sonde (4) und die Innenwand des Außenrohres in mechanischem und gegebenenfalls in elektrischem Kontakt stehen, um die Sonde (4) an ihrer Stelle zu blockieren, wenn die beiden Halbrohre in eine zweite, einander angenäherte Stellung der Benutzung des Synthesizers gebracht sind,
und dadurch, dass
- die Sonde (4) mindestens einen Arm (3) zur Verschiebung der Sonde aufweist, der sich in einen Raum erstreckt, der die beiden Halbrohre trennt, und in der ersten Stellung der Halbrohre zueinander, voneinander entfernt, ermöglicht, die Sonde zu verschieben.

2. Impedanz-Synthesizer nach Patentanspruch 1, in dem die beiden Halbrohre durch Verschiebung längs einer Achse (Oz) zueinander versetzbar sind, die auf dem in Längsrichtung verlaufenden Zentralleiter (1) senkrecht verläuft, oder durch Drehung um eine Achse (Oz), die auf dem in Längsrichtung verlaufenden Zentralleiter (1) senkrecht steht, oder durch Drehung um eine zum in Längsrichtung verlaufenden Zentralleiter (1) parallele Achse.

3. Impedanz-Synthesizer nach Patentanspruch 2, ein Wirkglied (8) für die Verschiebung der beiden Halbrohre zueinander umfassend.

4. Impedanz-Synthesizer nach einem der Patentansprüche 1 bis 3, in dem die Sonde (4) mindestens zwei Teile (41, 42) aufweist, die abnehmbar aneinander befestigt sind, so dass die Sonde (4) abnehmbar um den Leiter (1) montiert werden kann.

5. Impedanz-Synthesizer nach Patentanspruch 4, ein gemeinsames Wirkglied (9) für die beiden Teile (41, 42) aufweisend.

6. Impedanz-Synthesizer nach einem der Patentansprüche 1 bis 5, ein Wirkglied (7) umfassend, das auf den oder jeden Verschiebungsarm (3) einwirkt.

7. Impedanz-Synthesizer nach einem der Patentansprüche 1 bis 6, in dem die äußere Peripherie der Sonde und die Innenwand des Außenrohres über die gesamte Peripherie der Sonde miteinander in Berührung stehen, wenn sich die beiden Halbrohre in ihrer zweiten Stellung zueinander befinden.

8. Impedanz-Synthesizer nach einem der Patentansprüche 1 bis 7, mehre Sonden (4) aufweisend.

9. Impedanz-Synthesizer nach Patentanspruch 8, eine Gruppe (44) von mindestens zwei Sonden (4) umfassend, die mindestens einen Verschiebungsarm (3) miteinander gemeinsam haben.

## Claims

1. A coaxial impedance synthesizer, comprising:
- a central longitudinal (Ox) conductor (1),
- an outer conductive tube (2) coaxial with the conductor (1),
- at least one probe (4) mounted around the central conductor (1) in longitudinal translation,
the coaxial impedance synthesizer being **characterized in that**:
- the outer tube (2) comprises two separable half-tubes displaceable between two mutual positions, such that:
o when the two half-tubes are brought into a first position away from each other, for adjusting the synthesizer, the probe (4) is allowed to move longitudinally relative to the central conductor (1) towards a desired position , and
o when the two half-tubes are brought into a second position close to each other, for using the synthesizer, the outer periphery of the probe (4) and the inner wall of the outer tube are in mechanical and possibly electrical contact to block the prove (4) in position,
and **in that**:
- the probe (4) comprises at least one leg (3) for displacing the probe, extending in a space separating the two half-tubes and allowing to displace the probe in the first position, away from each other, of the two half-tubes.

2. An impedance synthesizer according to claim 1, wherein the two half-tubes are mutually displaceable by translation along an axis (Oz) perpendicular to the central longitudinal conductor (1), or by rotation about an axis perpendicular to the central longitudinal conductor (1), or by rotation around an axis parallel to the central longitudinal conductor (1).

3. An impedance synthesizer according to claim 2, including an actuator (8) for the mutual displacement of the two half-tubes.

4. An impedance synthesizer according to one of claims 1 to 3, wherein the probe (4) has at least two parts (41, 42), releasably fixed to each other, such that the probe (4) can be removably mounted around the conductor (1).

5. An impedance synthesizer according to claim 4, including a common actuator (9) for the two parts (41, 42).

6. An impedance synthesizer according to one of claims 1 to 5, including an actuator (7) operating at the or each displacement leg (3).

7. An impedance synthesizer according to one of claims 1 to 6, wherein, when the two half-tubes are in their second position close to each other, the outer periphery of the probe and the inner wall of the outer tube are in contact along the entire periphery of the probe.

8. An impedance synthesizer according to one of claims 1 to 7, including a plurality of probes (4).

9. An impedance synthesizer according to claim 8, including a group (44) of at least two probes (4) sharing at least one common displacement leg (3).
